# EUROPÄISCHE PATENTANMELDUNG

(11) **EP 4 404 706 A1**
(43) Veröffentlichungstag der Anmeldung: **24.07.2024**
(21) Anmeldenummer: 23152676.5
(22) Anmeldetag: 20.01.2023
(51) Int. Cl.: H05K 13/00

(54) **VERFAHREN ZUM AUTOMATISIERTEN POSITIONIEREN VON STÜTZEN**

(71) Anmelder: Siemens Aktiengesellschaft, 80333 München (DE)
(72) Erfinder: Kudella, Simon, 76185 Karlsruhe (DE)
(74) Vertreter: Siemens Patent Attorneys

(57) **Zusammenfassung**

Vorgeschlagen wird ein Verfahren zum automatisierten Erstellen einer digitalen Verteilungskarte für eine Positionierung für Stützen (3a, 3b, 3c, 18a, 18b) für eine Leiterplatte (1), welche eine erste Flächenseite (4) und eine zweite Flächenseite (5) aufweist, wobei die Stützen (3a, 3b, 3c, 18a, 18b) dafür vorgesehen sind, die Leiterplatte (1) während eines Verarbeitungsverfahrens mechanisch zu stützen, um Beschädigungen der Leiterplatte (1) zu verhindern, das Verfahren umfassend:
a) Erzeugen einer digitalen, leeren Verteilungskarte für die Stützen;
b) Unter Zuhilfenahme einer digitalen, wenigstens zweidimensionalen Repräsentation (6) der Leiterplatte (1), Ermitteln aller möglicher Positionen (17) für die Stützen (3a, 3b, 3c, 18a, 18b) auf der ersten Flächenseite (4) und/oder der zweiten Flächenseite (5) der Leiterplatte (1) durch ein Prüfen im Wesentlichen jeder Position (17) auf der ersten Flächenseite (4) und/oder der zweiten Flächenseite (5) der Leiterplatte (1), dahingehend, ob eine hier anstoßende Stütze (3a, 3b, 3c, 18a, 18b) eine auf der Leiterplatte (1) angebrachte Komponente (2a, 2b, 2c) berühren würde, oder ob die Leiterplatte (1) an dieser Position (17) eine Aussparung (20) aufweist,
c) Befüllen der digitalen, leeren Verteilungskarte mit den zuvor identifizierten Positionen (17).

## Beschreibung

Die Erfindung betrifft ein Verfahren zum automatisierten Erstellen einer digitalen Verteilungskarte für eine Positionierung für Stützen für eine Leiterplatte. Außerdem betrifft die Erfindung ein Verarbeitungsverfahren zur Verarbeitung einer Leiterplatte und ein Computerprogrammprodukt.

In einer Elektronikfertigung, die beispielsweise ein SMT-Lötverfahren einsetzt, müssen in der Regel mehrere Teilprozesse für jedes einzelne Produkt definiert werden. Obwohl die meisten Produktionsstandorte Standardregeln für das Prozessdesign folgen, wird jeder Teilprozess manuell von den Bedienern oder Ingenieuren definiert. Je nach Produktspektrum kann es sich dabei um Tausende von manuellen Aufgaben handeln.

Ein häufig auftretendes Problem bei diesen Aufgaben ist die physische Unterstützung der Leiterplatte (engl. PCB) während der Verarbeitung. Je nach Prozess müssen verschiedene Anforderungen an den Leiterplattenträger erfüllt werden, abhängig von produktspezifischen Eigenschaften wie dem Layout und der Komponentenverteilung. Diese Abhängigkeiten sind beispielsweise besonders kritisch für den Lotpastenschablonendruck.

In den letzten Jahren ist die Verwendung von Stützstiften bekannt geworden, da sie einen häufigeren Produktwechsel und eine flexible Fertigung ermöglichen. Bisher wurde jedoch keine Lösung für das Problem bereitgestellt, eine vorteilhafte Platzierung eines solchen Stützstifts (bzw. einer Vielzahl von Stützstiften) automatisiert identifizieren zu können.

Während die Maschinenhersteller für SMT-Bearbeitungsmaschinen immer mehr die Möglichkeit bieten, die Pins an der Maschine selbst zu platzieren, sind die Programmierung und Definition von Positionen immer noch Aufgaben, die von einem Bediener erledigt werden müssen. Einige Anbieter unterstützen den Bediener, indem sie Informationen über das Schablonenlayout oder ein Bild der Leiterplatte bereitstellen. Bisher muss der Bediener noch identifizieren, welche Pin-Platzierungspositionen potenziell am besten geeignet sein könnten. Dazu muss er manuell das Panel-Layout, die Produkteigenschaften und die Kritikalität bestimmter Bereiche für den spezifischen Prozess sowie die aktuell platzierten Komponenten miteinander abgleichen.

In der EP 0 280 919 A2 sind ein Verfahren und eine Vorrichtung zum Ausrichten einer Trägerplatte für gedruckte Schaltungen gegenüber der Druckeinrichtung einer Maschine zur Bearbeitung von gedruckten Schaltungen offenbart.

Der Erfindung liegt die Aufgabe zugrunde, eine Positionierung von Stützen für eine Leiterplatte im Rahmen einer Verarbeitung der Leiterplatte zu verbessern.

Diese Aufgabe wird gelöst durch ein Verfahren zum automatisierten Erstellen einer digitalen Verteilungskarte für eine Positionierung für Stützen für eine Leiterplatte mit den Merkmalen des Anspruchs 1. Zudem wird die Aufgabe gelöst durch ein Verarbeitungsverfahren zur Verarbeitung einer Leiterplatte mit den Merkmalen des Anspruchs 12. Weiterhin wird die Aufgabe gelöst durch ein Computerprogrammprodukt mit den Merkmalen des Anspruchs 13. Vorteilhafte Weiterbildungen ergeben sich aus den abhängigen Ansprüchen.

Das erfindungsgemäße Verfahren zum automatisierten Erstellen einer digitalen Verteilungskarte für eine Positionierung für Stützen für eine Leiterplatte, welche eine erste Flächenseite und eine zweite Flächenseite aufweist, wobei die Stützen dafür vorgesehen sind, die Leiterplatte während eines Verarbeitungsverfahrens mechanisch zu stützen, um Beschädigungen der Leiterplatte zu verhindern und die Prozessqualität sicherzustellen, umfasst die folgenden Verfahrensschritte:
a) Erzeugen einer digitalen, leeren Verteilungskarte für die Stützen;
b) Unter Zuhilfenahme einer digitalen, wenigstens zweidimensionalen Repräsentation der Leiterplatte, Ermitteln aller möglicher Positionen für die Stützen auf der ersten Flächenseite und/oder der zweiten Flächenseite der Leiterplatte durch ein Prüfen im Wesentlichen jeder Position auf der ersten Flächenseite und/oder der zweiten Flächenseite der Leiterplatte, dahingehend, ob eine hier anstoßende Stütze eine auf der Leiterplatte angebrachte Komponente berühren würde, oder ob die Leiterplatte an dieser Position eine Aussparung aufweist,
c) Befüllen der digitalen, leeren Verteilungskarte mit den zuvor identifizierten Positionen.

Die für die Erfindung wesentliche Idee besteht darin, auf eine digitale, wenigstens zweidimensionale Repräsentation der Leiterplatte zurückzugreifen. Bei dieser Repräsentation kann es sich in einem Fall um eine fotografische Aufnahme der Leiterplatte handeln. Über an sich bekannte Bildauswerteverfahren können die möglichen Positionen für die Stützen auf einer oder beiden Flächenseiten der Leiterplatte ermittelt werden. Es können aber auch vollständig digitale Repräsentationen wie eine CAD-Datei der Leiterplatte verwendet werden. Diese CAD-Dateien liegen in der Regel vor und können direkt verwendet werden, ohne dass Bilderkennungsverfahren vonnöten wären.

Im Rahmen der Ermittlung kann geprüft werden, an welchen Positionen auf der Leiterplatte sich Aussparungen, Vertiefungen, Komponenten oder sonstige Hindernisse befinden, die einer Positionierung einer Stütze entgegenstehen. Durch das erfindungsgemäße Verfahren werden die Positionen auf der Leiterplatte, an denen eine Stütze positioniert werden kann, automatisiert ermittelt und in eine digitale Verteilungskarte eingetragen. Die digitale Verteilungskarte kann eine Matrixform aufweisen, welche sich besonders im Kontext der flächigen Form der Leiterplatte eignet und von Rechenmitteln wie einer CPU einfach verarbeitet werden kann. Sie kann im Rahmen des beschriebenen Verfahrens mit binären Informationen befüllt werden: 1 für "Positionierung einer Stütze möglich", 0 für "Positionierung einer Stütze nicht möglich").

Diese digitale Verteilungskarte kann danach weiteren Verarbeitungsschritten, ggf. Optimierungen, zugeführt werden. Insbesondere kann die Verteilungskarte für die tatsächliche Positionierung der Stützen im Rahmen einer Verarbeitung der Leiterplatte eingesetzt werden.

Das erfindungsgemäße Verfahren reduziert den Aufwand für einen Anwender im Vorfeld und während eines Verarbeitungsverfahrens der Leiterplatte beträchtlich, indem es zuvor manuell durchgeführte Tätigkeiten besonders vorteilhaft automatisiert.

Im Rahmen einer bevorzugten Weiterbildung der Erfindung erfolgt vor dem Verfahrensschritt a eine Abfrage an einen Anwender, für welche der Flächenseiten der Leiterplatte das Verfahren durchgeführt werden soll. In bestimmten Fällen kann es vorteilhaft sein, wenn der Anwender vorgeben kann, welcher der beiden Flächenseiten (d.h. die beiden Seiten mit den betragsmäßig größten Oberflächen der Leiterplatte) von den Stützen unterstützt werden soll.

Bevorzugt umfasst das Verfahren zusätzlich die folgenden Verfahrensschritte:
- Unter Zuhilfenahme einer digitalen Beschreibung des Verarbeitungsverfahrens, Ermitteln, an welchen der Positionen auf welche Art, insbesondere mit welcher Kraft, im Rahmen des Verarbeitungsverfahrens auf die Leiterplatte eingewirkt werden soll,
- Korrelieren der bereits befüllten digitalen Verteilungskarte mit den zusätzlich ermittelten Positionen.

Mit anderen Worten wird im Rahmen dieser Weiterbildung des erfindungsgemäßen Verfahrens eine Kritikalität des durchzuführenden Verarbeitungsverfahrens hinsichtlich jeder Position auf der Leiterplatte ermittelt. Die Kritikalität wird dabei dadurch ermittelt, dass unter Zuhilfenahme der digitalen Beschreibung des Verarbeitungsverfahrens geprüft wird, in welchem Maß und auf welche Art im Rahmen des Verarbeitungsverfahrens auf die jeweilige Position der Leiterplatte eingewirkt werden wird. Die digitale Beschreibung des Verarbeitungsverfahrens kann dabei eine Art Ablaufschema sein, zu welcher Zeit wie lange und auf welche Art und Weise auf die Leiterplatte eingewirkt werden soll. Beispielsweise kann bei einem Schablonendruckverfahren eine Größe von Öffnungen der Schablone für die Bewertung der Kritikalität verwendet werden. Bei einer Bestückung der Leiterplatte mit einer Komponente wie einem Widerstand oder einer Induktivität kann ein wichtiger Parameter die Geometrie der Komponente oder auch die Kraft sein, mit der die Komponente gegen die Leiterplatte gedrückt wird, um diese zu fixieren.

Nach der Ermittlung der Art, mit der an den jeweiligen Positionen auf die Leiterplatte eingewirkt werden soll, werden die Ergebnisse mit der zuvor bereits befüllten digitalen Verteilungskarte korreliert.

Durch die zusätzliche Berücksichtigung der Einwirkungen durch das Verarbeitungsverfahren kann die Positionierung (automatisiert) weiter verbessert werden. Insbesondere wird noch stärker berücksichtigt, wo die Leiterplatte in welchem Maß Unterstützung durch eine Stütze benötigt.

Für den Fall, dass das Verarbeitungsverfahren ein Schablonendruckverfahren umfasst, kann vorteilhafterweise unter Zuhilfenahme der digitalen Beschreibung des Verarbeitungsverfahrens ermittelt werden, entlang welcher Bahnen ein Rakel über die Schablone geführt werden soll, um die Einwirkung des Verarbeitungsverfahrens auf die Leiterplatte zu ermitteln. Die Rakel kann bei einer unzureichenden Unterstützung der Leiterplatte zu einem Biegen der Leiterplatte führen, was die Qualität des Verarbeitungsverfahrens beeinträchtigen kann. Durch die gezielte Berücksichtigung der Einwirkung des Rakels auf die Leiterplatte kann für den Fall des Schablonendruckverfahrens so gezielt eine Beeinträchtigung der Qualität des Verarbeitungsverfahrens verringert oder ganz verhindert werden.

Im Rahmen einer bevorzugten Weiterbildung der Erfindung umfasst das Verfahren weiterhin die folgenden Verarbeitungsschritte:
- Unter Zuhilfenahme einer digitalen, dreidimensionalen Repräsentation der Leiterplatte Ermitteln, welchen Unterstützungsgrad die einzelnen Positionen der Leiterplatte aufweisen,
- Korrelieren der bereits befüllten digitalen Verteilungskarte mit dem jeweiligen, zuvor ermittelten Unterstützungsgrad der Positionen.

Bei der dieser Weiterbildung wird zusätzlich eine dritte Dimension der Leiterplatte berücksichtigt und ein Unterstützungsgrad der einzelnen Positionen der Leiterplatte ermittelt. Dabei können beispielsweise eine Dicke der Leiterplatte und/oder ein Material der Leiterplatte und/oder auf der Leiterplatte angeordnete Komponenten für die Ermittlung des Unterstützungsgrades hinzugezogen werden. Dabei kann davon ausgegangen werden, dass eine dickere Leiterplatte, ein festeres/steiferes Material und große, flächige Komponenten einen höheren Unterstützungsgrad mit sich bringen.

Besonders bevorzugt werden für die Ermittlung des Unterstützungsgrades der jeweiligen Positionen bereits vorgesehene Stützen zur Stützung der Leiterplatte berücksichtigt. Dahinter steht die Erkenntnis, dass eine Position potenziell weniger Unterstützung benötigt, wenn bereits Stützen vorhanden bzw. vorgesehen sind, die die Leiterplatte auch an dieser Position (mit) stützen.

Der Unterstützungsgrad kann dabei unter Berücksichtigung eines euklidischen Abstandes der jeweiligen Position auf der Leiterplatte von bereits vorgesehenen Stützen ermittelt werden. Je geringer der Abstand zu den bereits vorgesehenen Stützen ist, desto höher ist die Unterstützung durch die benachbarten Stützen für die Leiterplatte an der betreffenden Position.

Es kann jedoch vorkommen, dass die Unterstützung trotz eines kleinen euklidischen Abstandes nicht sehr hoch ist. Dies kann beispielsweise durch eine Aussparung entlang eines Verbindungsweges zwischen der oder den vorgesehenen Stützen und der betreffenden Position bedingt sein. Daher kann bevorzugt der Unterstützungsgrad zusätzlich unter Berücksichtigung einer Topologie der Leiterplatte entlang wenigstens eines Verbindungsweges zwischen der jeweiligen Position und den bereits vorgesehenen Stützen ermittelt werden. Die Topologie ist der digitalen, dreidimensionalen Repräsentation der Leiterplatte zu entnehmen und beinhaltet Informationen bezüglich der dreidimensionalen Struktur der Leiterplatte zwischen den betreffenden Positionen.

Im Zuge der Berücksichtigung der Topologie können verschiedene Berechnungsmethoden eingesetzt werden. In einer einfachen Annahme kann beispielsweise der Unterstützungsgrad, der der Leiterplatte durch eine benachbarte Stütze an einer bestimmten Position gewährt wird, als Null angenommen werden, wenn kein direkter Verbindungsweg zwischen der Stütze und der betreffenden Position vorliegt (aufgrund einer dazwischen liegenden Aussparung). Es können aber auch deutlich komplexere Berechnungen wie die Ermittlung aller Wegintegrale zwischen der Stütze und der betreffenden Position durchgeführt werden, die eine höhere Genauigkeit des tatsächlichen Unterstützungsgrades mit sich bringen. Auch eine Berechnung unter Zuhilfenahme von finiten Elementen ist möglich, um den Unterstützungsgrad zu ermitteln. Vorteilhafterweise kann der Anwender zwischen verschiedenen Berechnungsmethoden auswählen, um ein für den jeweiligen Anwendungsfall hinsichtlich Genauigkeit bzw. Aufwand am passendsten erscheinendes Berechnungsverfahren wählen zu können.

Im Anschluss an das Erstellen der digitalen Verteilungskarte wird diese vorteilhafterweise dafür verwendet, die vorzusehenden Stützen an den zuvor ermittelten Positionen automatisiert in Kontakt mit der Leiterplatte zu bringen. Es ist auch möglich, dass die erstellte digitale Verteilungskarte für eine nachfolgende Optimierung verwendet wird, bevor sie beispielsweise für die tatsächliche Positionierung der Stützen verwendet wird.

Nach der Durchführung des Verarbeitungsverfahrens kann eine Beanspruchung der einzelnen Stützen (beispielsweise kamerabasiert oder mithilfe spezieller Sensorik) ermittelt werden, um hieraus Rückschlüsse für eine nachfolgende Überarbeitung der digitalen Verteilungskarte ziehen zu können.

Die zuvor formulierte Aufgabe wird zudem gelöst durch ein Verarbeitungsverfahren zur Verarbeitung einer Leiterplatte, dadurch gekennzeichnet, dass die Leiterplatte während des Verarbeitungsverfahrens der Leiterplatte von Stützen gestützt werden, die gemäß einer digitalen Verteilungskarte positioniert worden sind, wobei die digitale Verteilungskarte gemäß einem Verfahren wie zuvor erläutert erstellt worden ist.

Die zuvor formulierte Aufgabe wird zudem gelöst durch ein Computerprogrammprodukt, umfassend Befehle, deren Ausführung durch einen Computer diesen veranlassen, ein Verfahren wie zuvor erläutert auszuführen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Es zeigen:
- FIG 1: eine Leiterplatte mit Stützen in einem Schnittbild;
- FIG 2: ein Ablaufdiagramm eines erfindungsgemäßen Verfahrens; und
- FIG 3: einen Ausschnitt einer Leiterplatte in einer Draufsicht.

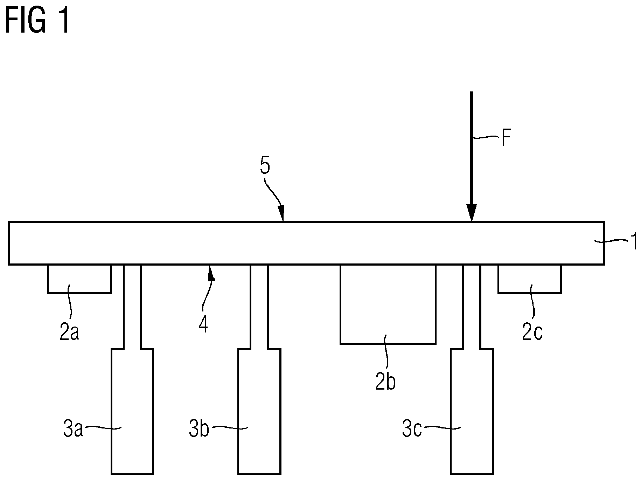

In FIG 1 ist eine Leiterplatte 1 in einem Schnittbild dargestellt. An einer ersten Flächenseite 4 (in FIG 1 an der unteren Seite der Leiterplatte 1) sind Komponenten 2a, 2b, 2c wie Transistoren, Widerstände, Spulen oder dergleichen angeordnet, welche mit der Leiterplatte 1 in Verbindung stehen. Zudem sind an der ersten Flächenseite 4 drei Stützen 3a, 3b, 3c angeordnet. Diese Stützen 3a, 3b, 3c sind aus einem geeigneten, elektrisch nichtleitenden Material wie Aluminiumoxid oder einem Kunststoff gefertigt und stützen die Leiterplatte 1 gegen (in FIG 1 nach unten) auf eine zweite Flächenseite 5 (in FIG 1 oben) wirkende Kräfte F ab.

Die Kräfte F entstehen durch ein Verarbeitungsverfahren, im Rahmen dessen über die zweite Flächenseite 5 auf die Leiterplatte 1 eingewirkt wird. Ohne das Vorsehen der Stützen 3a, 3b, 3c könnte es durch das Verarbeitungsverfahren zu Beschädigungen der Leiterplatte 1 bzw. der Komponenten 2a, 2b, 2c und/oder zu Qualitätsbeeinträchtigungen kommen. Die bislang manuell von einem Anwender mit hohem Aufwand durchgeführte Positionierung der Stützen 3a, 3b, 3c in Relation zu der Leiterplatte 1 wird im Zuge des im Folgenden beschriebenen Verfahrens durch eine effiziente, automatisierte Positionierung ersetzt.

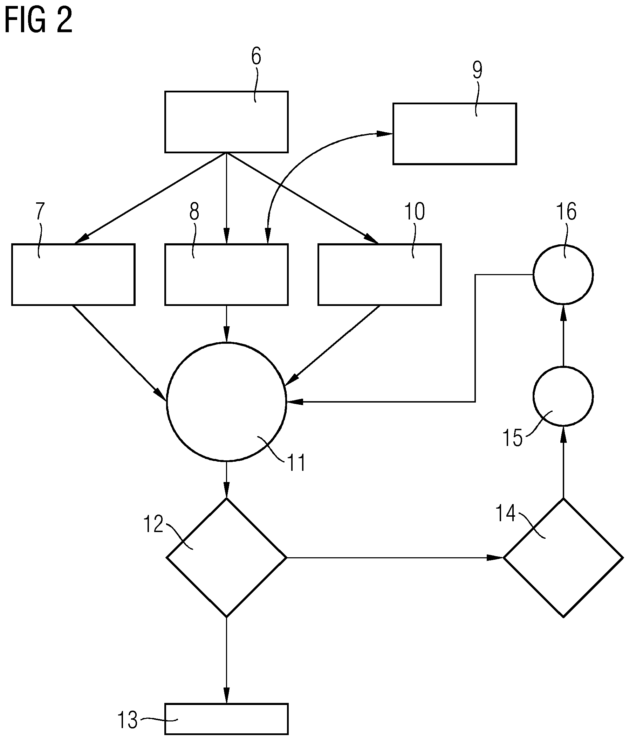

Ausgangspunkt für das in FIG 2 dargestellte Verfahren ist eine digitale, dreidimensionale Repräsentation 6 der Leiterplatte 1. Dabei kann es sich um eine CAD-Datei (Computer Aided Design) handeln, die im Zuge der Auslegung der Leiterplatte 1 von einem Hersteller der Leiterplatte 1 entworfen worden ist. Zunächst wird eine digitale, leere Verteilungskarte erzeugt, die eine Matrixform aufweist.

In einem ersten nachfolgenden Schritt 7 werden alle möglichen Positionen für Stützen 3a, 3b, 3c auf der Leiterplatte 1 ermittelt. Hierfür wird ermittelt, an welchen Positionen keine Stütze 3a, 3b, 3c angebracht werden kann, da hier beispielsweise eine Komponente 2a, 2b, 3c angeordnet ist oder sich hier eine Aussparung in der Leiterplatte 1 befindet. Diese Positionen werden in einer Matrixform digital festgehalten.

In einem zweiten nachfolgenden Schritt 8 wird unter Zuhilfenahme einer digitalen Beschreibung 9 des an der Leiterplatte 1 vorzunehmenden Verarbeitungsverfahrens ermittelt, an welchen Positionen der Leiterplatte 1 auf welche Art, insbesondere mit welcher Kraft, im Rahmen des Verarbeitungsverfahrens auf die Leiterplatte 1 eingewirkt werden soll. Diese Positionen werden gleichfalls in einer Matrixform digital festgehalten.

In einem dritten nachfolgenden Schritt 10 wird unter Zuhilfenahme der digitalen, dreidimensionalen Repräsentation 6 der Leiterplatte 1 ermittelt, welchen Unterstützungsgrad die einzelnen Positionen der Leiterplatte 1 aufweisen. Dabei wird der Unterstützungsgrad unter Berücksichtigung einer Dicke der Leiterplatte 1, und eines Materials der Leiterplatte 1, und von den auf der Leiterplatte 1 angeordneten Komponenten 2a, 2b, 2c ermittelt. Zusätzlich werden bereits vorgesehene Stützen berücksichtigt (bei dem ersten Durchgang des Verfahrens können auch keine Stützen bereits vorgesehen sein). Der Unterstützungsgrad der jeweiligen Positionen wird in einer Matrixform digital festgehalten.

In einem darauffolgenden Schritt 11 werden die drei zuvor ermittelten Matrizen miteinander korreliert und das Ergebnis in der digitalen Verteilungskarte hinterlegt. Diese digitale Verteilungskarte könnte bereits dazu verwendet werden, das tatsächliche Vorsehen der Stützen an der Leiterplatte 1 zu initiieren.

In FIG 2 ist eine optionale Optimierungsschleife dargestellt: In einem darauffolgenden Schritt 12 wird geprüft, ob eine verbleibende Kritikalität größer als ein von dem Anwender festgelegter Schwellenwert ist. Die verbleibende Kritikalität wird dabei dadurch berechnet, dass die Matrizen der Schritte 8 und 9 miteinander multipliziert werden. Wird der Schwellenwert nicht überschritten, liegt bereits ein für den Anwender optimales Ergebnis 13 vor.

Wird der Schwellwert überschritten, wird im Rahmen eines weiteren Schrittes 14 geprüft, ob noch mögliche Positionen für Stützen offen sind. Es wird mit anderen Worten geprüft, ob noch weitere Stützen an der Leiterplatte 1 angebracht werden können. Falls dies der Fall ist, werden an den Positionen, an denen die verbleibende Kritikalität am größten ist und eine Unterstützung gemäß dem Schritt 7 möglich ist, zusätzliche Stützen vorgesehen. In einem darauffolgenden Schritt 16 wird der Unterstützungsgrad (vgl. Schritt 10) neu ermittelt, da sich dieser durch die zusätzlichen Stützen geändert haben kann.

Der überarbeitete Unterstützungsgrad wird dann bei einer erneuten Durchführung von Schritt 11 und 12 verwendet, bis ein für den Anwender optimales Ergebnis 13 ermittelt werden konnte.

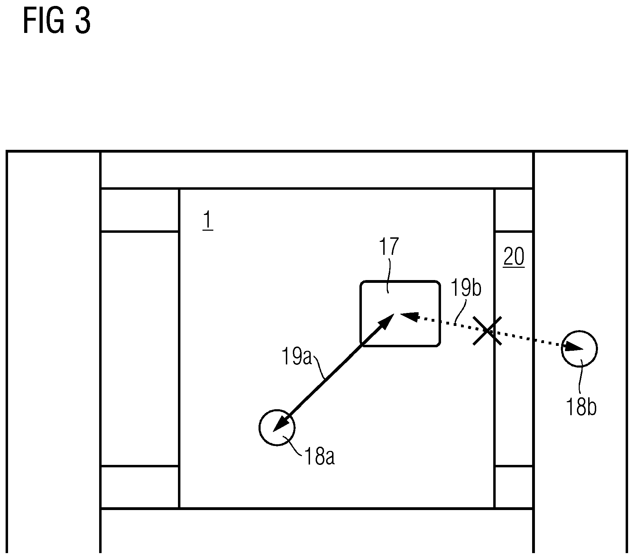

In FIG 3 ist eine Möglichkeit zur Ermittlung des Unterstützungsgrades einer Position 17 auf der Leiterplatte 1 schematisch dargestellt. Auf der Leiterplatte 1 sind hierbei bereits zwei Stützen 18a, 18b vorgesehen. Der direkte Verbindungsweg 19a zwischen der Stütze 18a und der Position 17 verläuft entlang der Leiterplatte 1, weshalb diese Stütze 18a zur Unterstützung der Position 17 beitragen kann. Die Position weist demnach einen von Null verschiedenen Unterstützungsgrad auf, der durch die Stütze 18a bedingt ist. Der direkte Verbindungsweg 19b zwischen der Stütze 18b und der Position 17 ist durch eine Aussparung 20 unterbrochen. Es wird hier vereinfacht davon ausgegangen, dass die Stütze 18b der Position 17 keine Unterstützung gewährt.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum automatisierten Erstellen einer digitalen Verteilungskarte für eine Positionierung für Stützen (3a, 3b, 3c, 18a, 18b) für eine Leiterplatte (1), welche eine erste Flächenseite (4) und eine zweite Flächenseite (5) aufweist, wobei die Stützen (3a, 3b, 3c, 18a, 18b) dafür vorgesehen sind, die Leiterplatte (1) während eines Verarbeitungsverfahrens mechanisch zu stützen, um Beschädigungen der Leiterplatte (1) zu verhindern, das Verfahren umfassend:
a) Erzeugen einer digitalen, leeren Verteilungskarte für die Stützen;
b) Unter Zuhilfenahme einer digitalen, wenigstens zweidimensionalen Repräsentation (6) der Leiterplatte (1), Ermitteln aller möglicher Positionen (17) für die Stützen (3a, 3b, 3c, 18a, 18b) auf der ersten Flächenseite (4) und/oder der zweiten Flächenseite (5) der Leiterplatte (1) durch ein Prüfen im Wesentlichen jeder Position (17) auf der ersten Flächenseite (4) und/oder der zweiten Flächenseite (5) der Leiterplatte (1), dahingehend, ob eine hier anstoßende Stütze (3a, 3b, 3c, 18a, 18b) eine auf der Leiterplatte (1) angebrachte Komponente (2a, 2b, 2c) berühren würde, oder ob die Leiterplatte (1) an dieser Position (17) eine Aussparung (20) aufweist,
c) Befüllen der digitalen, leeren Verteilungskarte mit den zuvor identifizierten Positionen (17).

2. Verfahren nach Anspruch 1, bei dem vor dem Verfahrensschritt a eine Abfrage an einen Anwender erfolgt, für welche der Flächenseiten (4, 5) der Leiterplatte (1) das Verfahren durchgeführt werden soll.

3. Verfahren nach Anspruch 1 oder 2, weiterhin umfassend die Verfahrensschritte:
- Unter Zuhilfenahme einer digitalen Beschreibung (9) des Verarbeitungsverfahrens, Ermitteln, an welchen der Positionen (17) auf welche Art, insbesondere mit welcher Kraft, im Rahmen des Verarbeitungsverfahrens auf die Leiterplatte (1) eingewirkt werden soll,
- Korrelieren der bereits befüllten digitalen Verteilungskarte mit den zusätzlich ermittelten Positionen (17).

4. Verfahren nach Anspruch 3, bei dem das Verarbeitungsverfahren ein Schablonendruckverfahren umfasst, wobei unter Zuhilfenahme der digitalen Beschreibung (9) des Verarbeitungsverfahrens ermittelt wird, entlang welcher Bahnen ein Rakel über die Leiterplatte (1) geführt werden soll, um die Einwirkung des Verarbeitungsverfahrens auf die Leiterplatte (1) zu ermitteln.

5. Verfahren nach einem der vorangegangenen Ansprüche, weiterhin umfassend die Verfahrensschritte:
- Unter Zuhilfenahme einer digitalen, dreidimensionalen Repräsentation (6) der Leiterplatte (1) Ermitteln, welchen Unterstützungsgrad die einzelnen Positionen (17) der Leiterplatte (1) aufweisen,
- Korrelieren der bereits befüllten digitalen Verteilungskarte mit dem jeweiligen, zuvor ermittelten Unterstützungsgrad der Positionen (17).

6. Verfahren nach Anspruch 5, bei dem der Unterstützungsgrad ermittelt wird unter Berücksichtigung:
- einer Dicke der Leiterplatte (1), und/oder
- eines Materials der Leiterplatte (1), und/oder
- von auf der Leiterplatte (1) angeordneten Komponenten (2a, 2b, 2c).

7. Verfahren nach Anspruch 5 oder 6, bei dem der Unterstützungsgrad unter Berücksichtigung bereits vorgesehener Stützen (3a, 3b, 3c) zur Stützung der Leiterplatte (1) ermittelt wird.

8. Verfahren nach Anspruch 7, bei dem der Unterstützungsgrad unter Berücksichtigung eines euklidischen Abstandes der jeweiligen Position (17) auf der Leiterplatte (1) von bereits vorgesehenen Stützen (3a, 3b, 3c, 18a, 18b) ermittelt wird.

9. Verfahren nach Anspruch 8, bei dem der Unterstützungsgrad zusätzlich unter Berücksichtigung einer Topologie der Leiterplatte (1) entlang wenigstens eines Verbindungsweges (19a, 19b) zwischen der jeweiligen Position (17) und den bereits vorgesehenen Stützen (3a, 3b, 3c, 18a, 18b) ermittelt wird.

10. Verfahren nach einem der vorangegangenen Ansprüche, bei dem die digitale Verteilungskarte eine Matrixform aufweist.

11. Verfahren nach einem der vorangegangenen Ansprüche, bei dem die Stützen (3a, 3b, 3c, 18a, 18b) unter Berücksichtigung der zuvor erstellten digitalen Verteilungskarte automatisiert in Kontakt mit der Leiterplatte (1) gebracht werden.

12. Verarbeitungsverfahren zur Verarbeitung einer Leiterplatte (1), **dadurch gekennzeichnet, dass** die Leiterplatte (1) während des Verarbeitungsverfahrens der Leiterplatte (1) von Stützen (3a, 3b, 3c, 18a, 18b) gestützt werden, die gemäß einer digitalen Verteilungskarte positioniert worden sind, wobei die digitale Verteilungskarte gemäß einem Verfahren nach einem der Ansprüche erstellt worden ist.

13. Computerprogrammprodukt, umfassend Befehle, deren Ausführung durch einen Computer diesen veranlassen, das Verfahren nach einem der Ansprüche 1 bis 11 auszuführen.
